# EUROPEAN PATENT SPECIFICATION

(11) **EP 3 280 156 B1**
(45) Date of publication and mention of the grant of the patent: **26.05.2021**
(21) Application number: 16772643.9
(22) Date of filing: 25.03.2016
(51) Int. Cl.: H04R 17/00, H01L 41/053, H01L 41/083, H01L 41/09, H01L 41/113, H01L 41/08, B06B 1/06

(54) **PIEZOELECTRIC ELEMENT AND ULTRASOUND SENSOR PROVIDED WITH SAME**
PIEZOELEKTRISCHES ELEMENT UND DAMIT AUSGESTATTETER ULTRASCHALLSENSOR
ÉLÉMENT PIÉZOÉLECTRIQUE ET CAPTEUR À ULTRASONS LE COMPORTANT

(30) Priority: 31.03.2015 JP 2015071943
(43) Date of publication of application: 07.02.2018
(73) Proprietor: Murata Manufacturing Co., Ltd., Nagaokakyo-shi, Kyoto 617-8555 (JP)
(72) Inventor: WATANABE, Kosuke, Nagaokakyo-shi, Kyoto 617-8555 (JP); NANBU, Koji, Nagaokakyo-shi, Kyoto 617-8555 (JP); FUJITA, Akio, Nagaokakyo-shi, Kyoto 617-8555 (JP)
(74) Representative: Reeve, Nicholas Edward
(86) International application number: PCT/JP2016/059652
(87) International publication number: WO 2016/158762

(56) References cited:
- WO-A1-2013/065359
- JP-A- H01 270 499
- JP-A- 2010 154 371
- JP-A- 2013 162 050
- JP-A- 2014 239 238
- JP-A- 2014 239 238

## Description

### Technical Field

The present invention relates to a piezoelectric element and an ultrasonic sensor including the same.

### Background Art

A general ultrasonic sensor provides a unimorph structure by bonding a piezoelectric element to an inner bottom surface of a case and transmits and receives ultrasonic waves by causing the bottom portion of the case to perform bending vibration. Japanese Patent Laying-Open No. 2002-204497 discloses an ultrasonic sensor including a multilayer piezoelectric element.

A plurality of electrodes are provided on an upper surface of a piezoelectric element bonded to an inner bottom surface of a case. When an FPC or the like is bonded to this upper surface of the piezoelectric element, it is common to individually establish electrical connections to the plurality of electrodes. Actually, however, an electrically-conductive material, e.g., solder, that should adhere to one electrode on the upper surface of the piezoelectric element may be unable to remain in a desired region and may overflow and come into contact with another adjacent electrode, which may cause a short circuit.

Accordingly, we have appreciated it would be desirable to provide a piezoelectric element and an ultrasonic sensor with reduced probability of occurrence of a short circuit caused by overflow of an electrically-conductive material used for bonding.

JP2010154371 discloses an ultrasonic sensor 10 for transmitting/receiving ultrasonic waves, which includes a piezoelectric element including a thin portion of thickness Ta and a thick portion, integrated with the thin portion and having a thickness Tb larger than that of the thin portion. Thin portion electrodes hold the thin portion therebetween; and thick portion electrodes hold the thick portion therebetween. The piezoelectric element brings the thickness Ta of the thin portion and the thickness Tb of the thick portion into a relation such that a resonant frequency fra in the thin portion and an anti-resonant frequency fab in the thick portion become equal.

JP2014239238 discloses a piezoelectric actuator that includes a laminate of an internal electrode and a piezoelectric layer, and a surface electrode connected electrically with the internal electrode on one principal surface of the laminate. The internal electrode includes a first pole and a second pole, the laminate includes an active part where the first pole and second pole of the internal electrode are superposed in the lamination direction, and an inactive part other than the active part. The active part is thicker than the inactive part, and the other principal surface between the side faces of the laminate is entirely flat.

JPH01270499 discloses an apparatus in which a common electrode is provided on one side of a diaphragm consisting of piezoelectric materials. A transmitting electrode and a receiving electrode are provided on the other side. The respective independent transmitting part and receiving part are formed by the electrodes. Thus, the effect of the reverberant signal on the receiving part due to the transmission is prevented, and the sensitivity is greatly enhanced.

### SUMMARY OF INVENTION

A piezoelectric element according to the present invention includes a stack formed of a plurality of piezoelectric layers and having a first main surface and a second main surface facing in opposite directions along a stacking direction, the stack includes a transmission portion, a reception portion, and a separating portion that separates the transmission portion and the reception portion from each other, a transmission electrode is arranged so as to cover a region of the first main surface corresponding to the transmission portion, a reception electrode is arranged so as to cover a region of the first main surface corresponding to the reception portion, the transmission electrode sandwiches at least a part of the plurality of piezoelectric layers, together with a conductor film arranged in the stack or on the second main surface, the reception electrode sandwiches at least a part of the plurality of piezoelectric layers, together with the conductor film arranged in the stack or on the second main surface, and at least a part of a region of the first main surface corresponding to the separating portion is convex in comparison with a region of the first main surface where the transmission electrode is arranged and a region of the first main surface where the reception electrode is arranged.

Preferably, in the above-described invention, the transmission portion and the reception portion include a structure in which the piezoelectric layers and the conductor films are alternately arranged therein, and in a plan view along the stacking direction, the separating portion includes a portion that does not include the conductor films therein.

An ultrasonic sensor according to the present invention includes: a case having a cylindrical shape with a bottom; the above-described piezoelectric element bonded to an inner bottom surface of the case such that the second main surface opposes the inner bottom surface of the case; and a wiring lead-out component including a plurality of wirings and bonded to the first main surface such that the plurality of wirings individually establish electrical connections to the reception electrode and the transmission electrode.

Preferably, in the above-described invention, the wiring lead-out component is bonded to the first main surface using an anisotropic electrically-conductive adhesive.

Preferably, in the above-described invention, the anisotropic electrically-conductive adhesive includes solder.

According to the present invention, it is possible to realize a piezoelectric element and an ultrasonic sensor with reduced probability of occurrence of a short circuit caused by overflow of an electrically-conductive material used for bonding.

### BRIEF DESCRIPTION OF DRAWINGS

Fig. 1 is a functional block diagram of a sensor device including an ultrasonic sensor in a first embodiment according to the present invention.
Fig. 2 is a cross-sectional view of the ultrasonic sensor in the first embodiment according to the present invention.
Fig. 3 is a plan view illustrating a piezoelectric element according to an embodiment of the present invention and an FPC bonded together.
Fig. 4 is a plan view of the piezoelectric element according to an embodiment of the present invention.
Fig. 5 is a perspective view of the piezoelectric element according to an embodiment of the present invention.
Fig. 6 is a perspective view also illustrating the internal structure of the piezoelectric element in the first embodiment according to the present invention.
Fig. 7 is an explanatory diagram of a combination of various electrodes included in the piezoelectric element according to an embodiment of present invention.
Fig. 8 is a cross-sectional view when seen in an arrow direction along a line VIII-VIII in Fig. 4 in a comparative example including a separating portion having a non-claimed concave region.
Fig. 9 is a cross-sectional view when seen in an arrow direction along a line IX-IX in Fig. 4 in a comparative example including a separating portion having a non-claimed concave region.
Fig. 10 is a cross-sectional view when seen in an arrow direction along a line X-X in Fig. 4 in a comparative example including a separation portion having a non-claimed concave region.
Fig. 11 is an explanatory diagram in a comparative example having a separating portion having a non-claimed concave region in which the concave region of a first main surface is hatched in the plan view of the piezoelectric element.
Fig. 12 is a first partial cross-sectional view in the vicinity of a bonding interface between the piezoelectric element and the FPC.
Fig. 13 is a second partial cross-sectional view in the vicinity of the bonding interface between the piezoelectric element and the FPC.
Fig. 14 is a first cross-sectional view of a piezoelectric element in a first embodiment according to the present invention, and differing from the comparative example by having a separating portion having a convex region.
Fig. 15 is a second cross-sectional view of the piezoelectric element in the first embodiment according to the present invention.
Fig. 16 is a third cross-sectional view of the piezoelectric element in the first embodiment according to the present invention.
Fig. 17 is a partial cross-sectional view in the vicinity of a bonding interface between the piezoelectric element in the first embodiment according to the present invention and an FPC.
Fig. 18 is a cross-sectional view of a piezoelectric element in a modification to the comparative example presented above.
Fig. 19 is a cross-sectional view of a piezoelectric element in a second embodiment according to the present invention.
Fig. 20 is a first explanatory diagram of a gap between electrodes of a piezoelectric element according to the present invention.
Fig. 21 is a second explanatory diagram of a gap between electrodes of a piezoelectric element according to the present invention.
Fig. 22 is a perspective view of one example of a three-terminal-type piezoelectric element.
Fig. 23 is a perspective view of the piezoelectric element turned over from the state illustrated in Fig. 22.
Fig. 24 is a schematic cross-sectional view of one example of the three-terminal-type piezoelectric element.
Fig. 25 is a perspective view of one example of a four-terminal-type piezoelectric element.
Fig. 26 is a perspective view of the piezoelectric element turned over from the state illustrated in Fig. 25.
Fig. 27 is a schematic cross-sectional view of one example of the four-terminal-type piezoelectric element.
Fig. 28 is a functional block diagram of a sensor device including an ultrasonic sensor in a third embodiment according to the present invention.

### DESCRIPTION OF EMBODIMENTS

Embodiments based on the present invention will be described hereinafter with reference to the drawings. When the number and an amount of components are referred, the scope of the present invention is not necessarily limited to the number and the amount of them unless otherwise specified. The same reference numerals denote the same components and equivalent components and overlapped description thereof is not repeated in some cases.

### First Embodiment

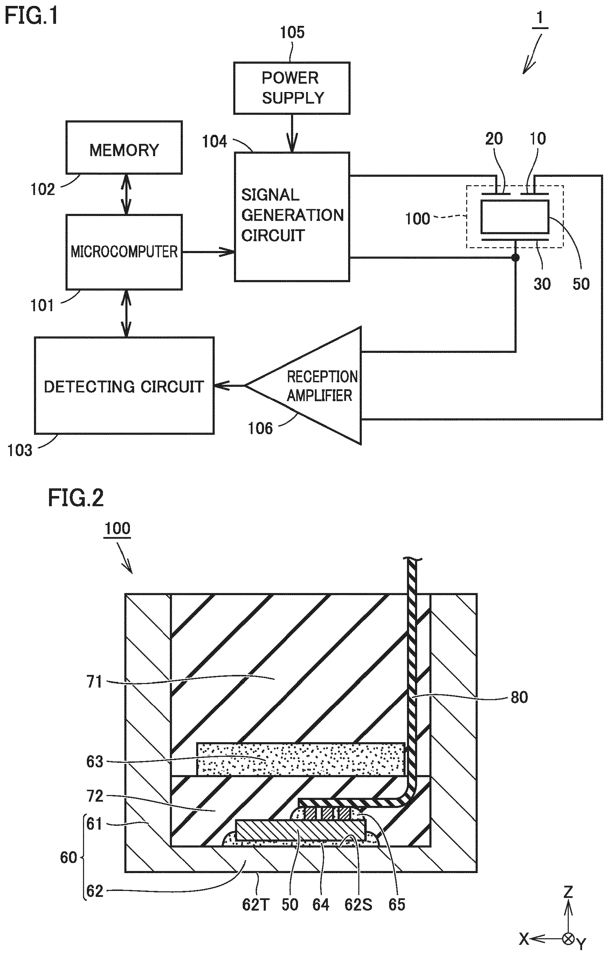

Fig. 1 is a diagram illustrating functional blocks of a sensor device 1 including an ultrasonic sensor 100 in a first embodiment. Sensor device 1 includes ultrasonic sensor 100, a microcomputer 101, a memory 102, a detecting circuit 103, a signal generation circuit 104, a power supply 105, and a reception amplifier 106. Ultrasonic sensor 100 includes a piezoelectric element 50, and piezoelectric element 50 has a three-terminal structure formed of electrodes 10, 20, and 30.

Microcomputer 101 reads out data stored in memory 102 and outputs a control signal to signal generation circuit 104. Signal generation circuit 104 generates an alternating-current (AC) voltage from the DC voltage based on the control signal. The AC voltage is supplied to ultrasonic sensor 100 and ultrasonic waves are transmitted into the air or the like from ultrasonic sensor 100. When ultrasonic sensor 100 receives reflected waves from a target, a reception signal generated in ultrasonic sensor 100 as a voltage value is transmitted to reception amplifier 106 and is input to microcomputer 101 through detecting circuit 103. Information related to presence or absence and movement of the target can be grasped with microcomputer 101.

### (Ultrasonic Sensor 100)

Fig. 2 is a cross-sectional view illustrating ultrasonic sensor 100 in the first embodiment. Ultrasonic sensor 100 includes a piezoelectric element 50, a case 60, a sound absorbing material 63, an adhesive 64, a bonding agent 65, fillers 71 and 72, and a flexible printed circuit (FPC) 80. Case 60 is formed to have electrical conductivity and have a cylindrical shape with a bottom. Case 60 is made of aluminum that has high elasticity and is lightweight, for example. Case 60 is produced by performing forging processing or cutting processing on aluminum, for example.

Case 60 includes a disk-like bottom portion 62 and a cylindrical portion 61 provided along a peripheral edge of bottom portion 62 and formed in a cylindrical shape. Bottom portion 62 has an inner bottom surface 62S and an outer surface 62T. Piezoelectric element 50 is made of PZT-based ceramics, for example. Piezoelectric element 50 is arranged on inner bottom surface 62S of bottom portion 62 and is bonded to inner bottom surface 62S using adhesive 64. Adhesive 64 is an epoxy-based adhesive, for example. When ultrasonic sensor 100 is driven, piezoelectric element 50 performs bending vibration together with bottom portion 62.

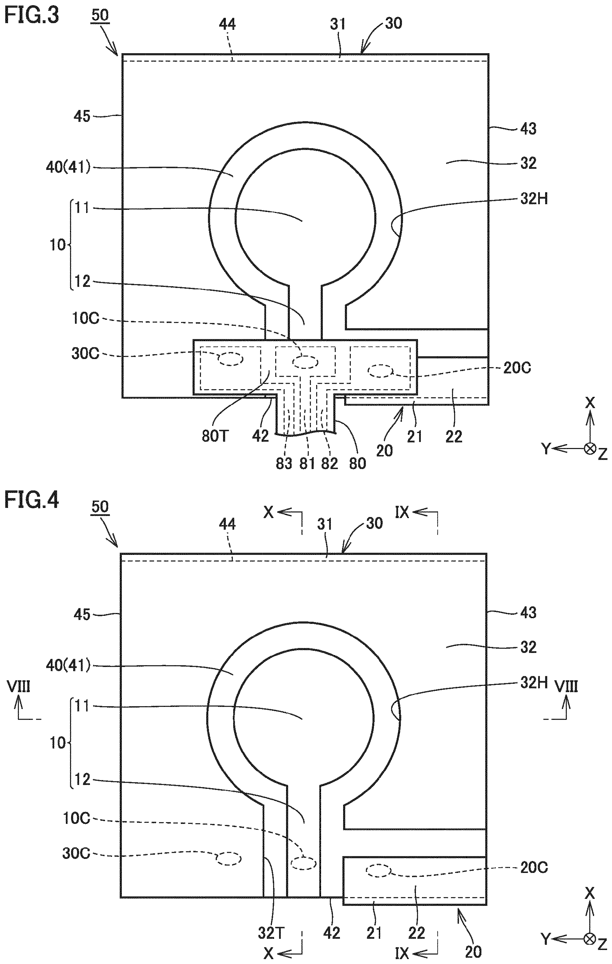

Piezoelectric element 50 includes three electrodes (not illustrated) (corresponding to electrodes 10 to 30 in Fig. 1, and details thereof will be described later). As illustrated in Fig. 3, a leading end portion 80T of FPC 80 has a T shape, for example. FPC 80 is electrically bonded to these electrodes with bonding agent 65 interposed therebetween. A resin material to which metal has been added is used as bonding agent 65, for example. A portion of FPC 80 at the side opposite to a portion thereof bonded to piezoelectric element 50 is extended to the outside of case 60 and is electrically connected to signal generation circuit 104 (Fig. 1), reception amplifier 106 (Fig. 1), and the like.

### (Piezoelectric Element 50)

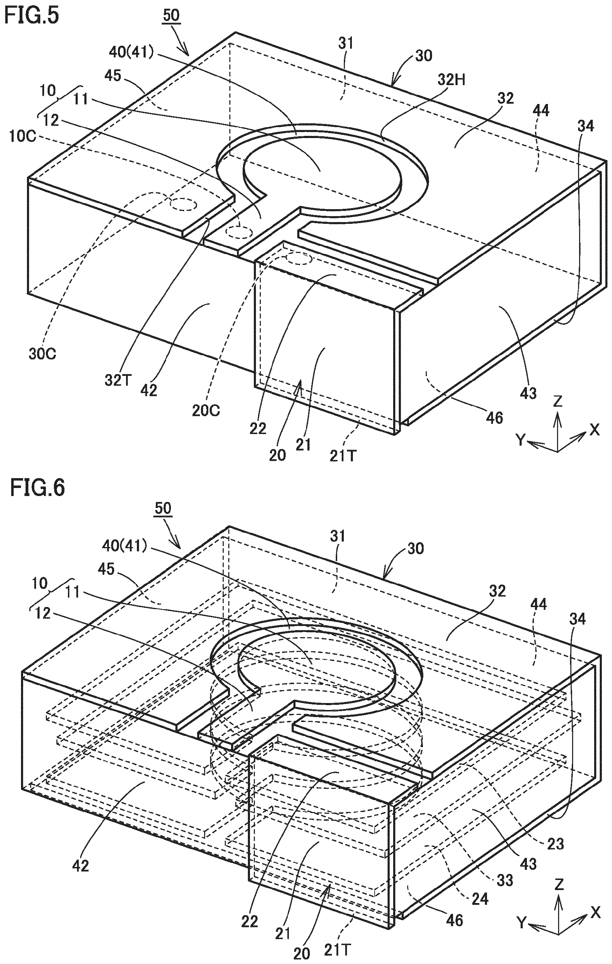

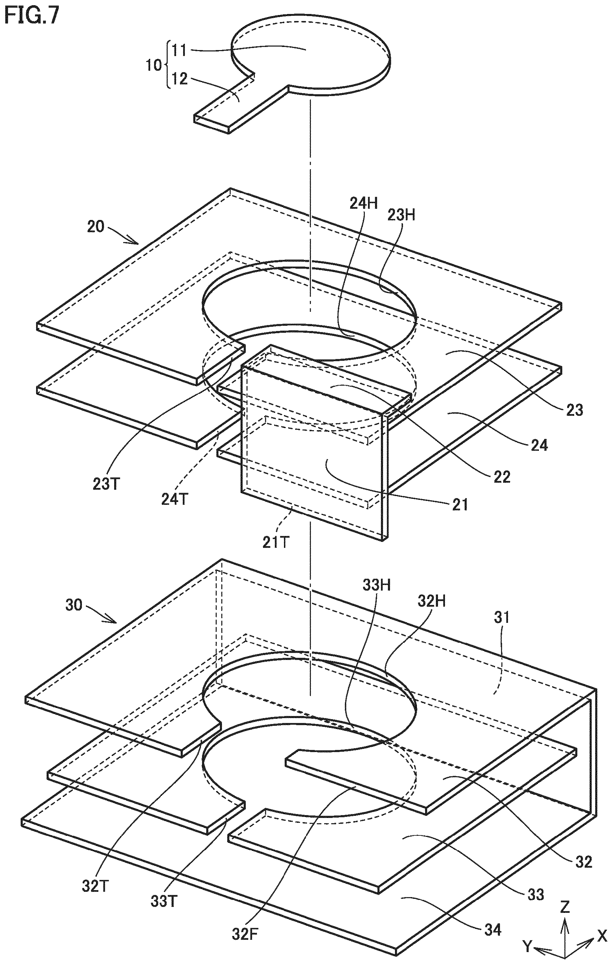

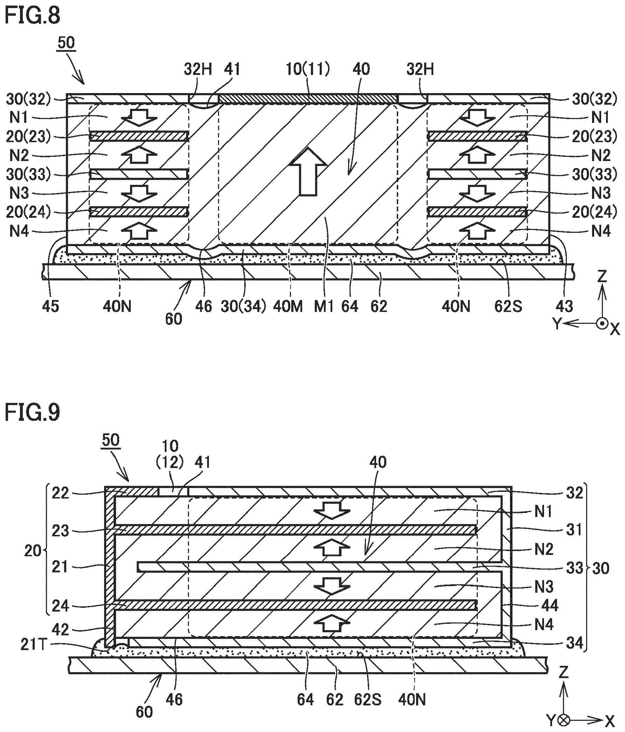

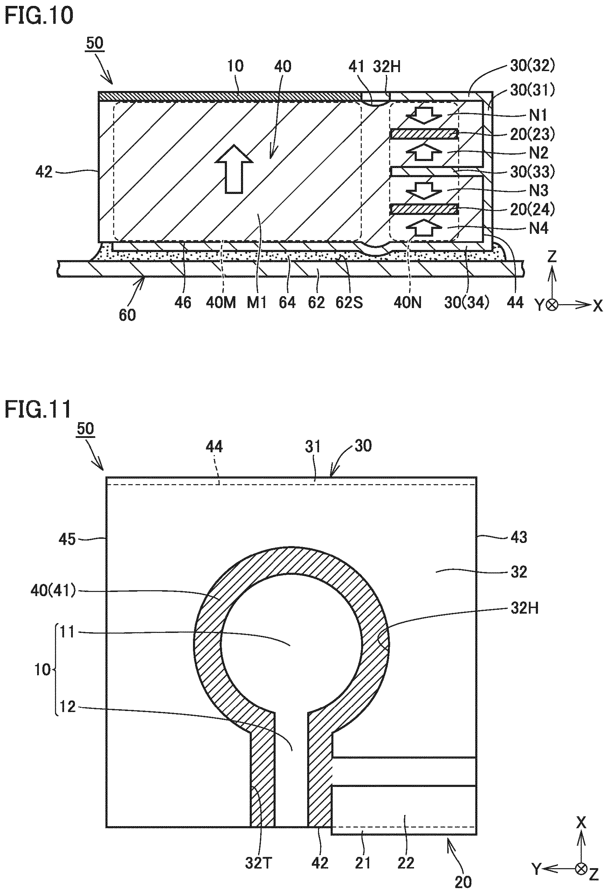

Fig. 3 is a plan view illustrating piezoelectric element 50 and FPC 80. Fig. 4 is a plan view illustrating piezoelectric element 50 (in a state in which FPC 80 is detached). Fig. 5 is a perspective view illustrating piezoelectric element 50. Fig. 6 is a perspective view illustrating piezoelectric element 50 and the internal structure thereof. Fig. 7 is an explanatory diagram of a combination of electrodes 10, 20, and 30 included in piezoelectric element 50. Fig. 8 is a cross-sectional view when seen in the arrow direction along a line VIII-VIII in Fig. 4. Fig. 9 is a cross-sectional view when seen in the arrow direction along a line IX-IX in Fig. 4. Fig. 10 is a cross-sectional view when seen in the arrow direction along a line X-X in Fig. 4.

In Fig. 3 to Fig. 10, arrows X, Y, and Z are indicated for the convenience of description. Arrows X, Y, and Z have a relation of being orthogonal to one another. Hereinafter, the respective configurations of piezoelectric element 50 are described with reference to arrows X, Y, and Z in some cases. However, arrangement relations of the respective configurations (characteristics related to orthogonality and parallelism) are not necessarily limited to arrangement relations as indicated by arrows X, Y, and Z. The same applies as well to Fig. 11 to Fig. 16 described later.

As illustrated in Fig. 3 to Fig. 10, piezoelectric element 50 is a multilayer piezoelectric element and is attached to inner bottom surface 62S of case 60 using adhesive 64. Piezoelectric element 50 has a rectangular parallelepiped shape including a longer side direction and a shorter side direction. Specifically, piezoelectric element 50 includes a piezoelectric layer 40 (Fig. 3 to Fig. 6 and Fig. 8 to Fig. 10), electrode 10 (Fig. 7), electrode 20 (Fig. 7), and electrode 30 (Fig. 7). The outer shape of piezoelectric layer 40 is a substantially rectangular parallelepiped shape (see Fig. 5 and Fig. 6) and piezoelectric layer 40 has an upper surface 41, side surfaces 42 to 45, and a lower surface 46.

Upper surface 41 is a main surface facing in one direction along a stacking direction of piezoelectric element 50, and is a surface of piezoelectric layer 40, which is located at the arrow Z direction side. Lower surface 46 is a surface of piezoelectric layer 40, which is located at the opposite direction side to the arrow Z direction. Side surfaces 42 and 44 are surfaces of piezoelectric layer 40, which are orthogonal to the arrow X direction, and have a positional relation of opposing each other. Side surfaces 43 and 45 are surfaces of piezoelectric layer 40, which are orthogonal to the arrow Y direction, and have a positional relation of opposing each other.

### (Electrode 10 (Reception Electrode))

Electrode 10 includes a disk portion 11 and an extending portion 12 (see Fig. 7). Electrode 10 functions as a reception electrode. Extending portion 12 has a shape extending toward the outer side from the outer edge of disk portion 11. Extending portion 12 is arranged so as to extend toward the side at which side surface 42 of piezoelectric layer 40 is located from the side at which disk portion 11 is located. As illustrated in Fig. 3, electrode 10 and FPC 80 (wiring pattern 81) are electrically connected on a portion (connecting place 10C) between wiring pattern 81 provided in FPC 80 and extending portion 12 of electrode 10 (also see Fig. 4 and Fig. 5).

### (Electrode 20 (Transmission Electrode))

Electrode 20 includes an end face portion 21, an upper surface portion 22, and intermediate portions 23 and 24 (see Fig. 7). Electrode 20 functions as a transmission electrode. That is to say, electrode 20 forms a potential difference between electrode 20 and electrode 30 by application of an AC voltage between electrodes 20 and 30. End face portion 21 opposes side surface 42 (Fig. 5) of piezoelectric layer 40 and makes contact with side surface 42. An end portion 21T of end face portion 21 is a section of electrode 20 which is located at the joining surface side (at the adhesive 64 side). End portion 21T has a shape extending along a part of a lower end portion of side surface 42 in the longer side direction of piezoelectric element 50.

Upper surface portion 22 of electrode 20 is provided being continuously connected to an end portion of end face portion 21 at the arrow Z direction side and is arranged on upper surface 41 of piezoelectric layer 40. Intermediate portions 23 and 24 are sections of electrode 20 which are arranged inside piezoelectric layer 40, and are not visually recognized in a state in which piezoelectric element 50 is completed (see Fig. 5). An intermediate portion 33 of electrode 30 is arranged between intermediate portion 23 and intermediate portion 24 (see Fig. 8 to Fig. 10, and the like). In the example illustrated here, intermediate portions 23 and 24 have been described as being configured to be visually unrecognizable from outside piezoelectric element 50. However, one or both of intermediate portions 23 and 24 may be configured to be visually recognizable from outside.

Hollowed portions 23H and 24H (Fig. 7) and cutout portions 23T and 24T are provided at the inner sides of intermediate portions 23 and 24, respectively. As illustrated in Fig. 7 and Fig. 9, end portions (specifically, end portions at the side where end face portion 21 is located) of intermediate portions 23 and 24 in the direction opposite to arrow X are connected to end face portion 21. On the other hand, end portions of intermediate portions 23 and 24 in the arrow X direction are not connected to an end face portion 31 of electrode 30, which will be described later, and are separated from end face portion 31. As illustrated in Fig. 3, electrode 20 and FPC 80 (wiring pattern 82) are electrically connected on a portion (connecting place 20C) between wiring pattern 82 provided in FPC 80 and upper surface portion 22 of electrode 20 (also see Fig. 4 and Fig. 5).

### (Electrode 30)

Electrode 30 as a grounded electrode includes end face portion 31, an upper surface portion 32, an intermediate portion 33, and a lower surface portion 34 (see Fig. 7). Electrode 30 functions as a common electrode. End face portion 31 opposes side surface 44 (Fig. 5) of piezoelectric layer 40 and makes contact with side surface 44. Lower surface portion 34 opposes lower surface 46 of piezoelectric layer 40 and makes contact with lower surface 46. Upper surface portion 32 is provided being continuously connected to an end portion of end face portion 31 at the arrow Z direction side and is arranged on upper surface 41 of piezoelectric layer 40. Intermediate portion 33 is a section of electrode 30 which is arranged inside piezoelectric layer 40, and is not visually recognized in the state in which piezoelectric element 50 is completed (see Fig. 5). In the example illustrated here, intermediate portion 33 has been described as being configured to be visually unrecognizable from outside piezoelectric element 50. However, intermediate portion 33 may be configured to be visually recognizable from outside.

Hollowed portions 32H and 33H (Fig. 7) are provided at the inner sides of upper surface portion 32 and intermediate portion 33, respectively. Disk portion 11 of electrode 10 is arranged at the inner side of hollowed portion 32H (see Fig. 5). Cutout portions 32T and 33T are also provided at the inner sides of upper surface portion 32 and intermediate portion 33, respectively. Extending portion 12 of electrode 10 is arranged at the inner side of cutout portion 32T (see Fig. 5). A retracted portion 32F is provided on a portion of upper surface portion 32 in the direction opposite to arrow Y. Retracted portion 32F is a section for permitting arrangement of upper surface portion 22 of electrode 20.

As illustrated in Fig. 7 and Fig. 9, end portions of upper surface portion 32, intermediate portion 33, and lower surface portion 34 in the arrow X direction are connected to end face portion 31. On the other hand, end portions of upper surface portion 32, intermediate portion 33, and lower surface portion 34 in the direction opposite to arrow X are not connected to end face portion 21 of electrode 20 and are separated from end face portion 21. As illustrated in Fig. 3, electrode 30 and FPC 80 (wiring pattern 83) are electrically connected on a portion (connecting place 30C) between wiring pattern 83 provided in FPC 80 and upper surface portion 32 of electrode 30 (also see Fig. 4 and Fig. 5).

### (Transmission Portion and Reception Portion)

Referring to Fig. 8 to Fig. 10, a transmission portion 40N and a reception portion 40M are formed in piezoelectric layer 40. Transmission portion 40N has a four-layer structure formed of first piezoelectric layers N1 to N4. First piezoelectric layers N1 to N4 are stacked in the direction of being distanced from bottom portion 62 of case 60 and are electrically connected in parallel by electrode 20 and electrode 30. Outlined arrows in Fig. 8 to Fig. 10 indicate polarization directions of the respective piezoelectric layers. On the other hand, reception portion 40M has a one-layer structure formed of a second piezoelectric layer M1.

Lower surface portion 34 of electrode 30 has a shape extending over both transmission portion 40N and reception portion 40M. Upper surface portion 22 of electrode 20 opposes lower surface portion 34 of electrode 30 with transmission portion 40N including first piezoelectric layers N1 to N4 interposed therebetween. Disk portion 11 of electrode 10 opposes lower surface portion 34 of electrode 30 with reception portion 40M including second piezoelectric layer M1 interposed therebetween.

That is to say, a region between upper surface portion 22 of electrode 20 and lower surface portion 34 of electrode 30, a region between intermediate portion 23 of electrode 20 and upper surface portion 32 of electrode 30, and a region between intermediate portion 23 of electrode 20 and lower surface portion 34 of electrode 30 in piezoelectric layer 40 function as transmission portion 40N. On the other hand, a region between disk portion 11 of electrode 10 and lower surface portion 34 of electrode 30 in piezoelectric layer 40 functions as reception portion 40M.

As illustrated in Fig. 8 and Fig. 10, transmission portion 40N and reception portion 40M are formed at positions adjacent to each other in the surface direction (X-Y plane direction) of inner bottom surface 62S of bottom portion 62 of case 60. To be specific, reception portion 40M is provided at a center portion of piezoelectric layer 40 and transmission portion 40N is provided on a peripheral portion as an outer side portion relative to reception portion 40M in the radial direction so as to surround reception portion 40M.

As illustrated in Fig. 9 and Fig. 10, in piezoelectric element 50, lower surface portion 34 of electrode 30 and end portion 21T of end face portion 21 of electrode 20 are located at the joining surface side of piezoelectric element 50 (at the side of the surface of piezoelectric element 50 joined to bottom portion 62 of case 60). Lower surface portion 34 of electrode 30 is attached to bottom portion 62 (inner bottom surface 62S) of case 60 using adhesive 64. As described above, electrode 20 forms a potential difference between electrode 20 and electrode 30 by application of an AC voltage between electrodes 20 and 30. As a result, ultrasonic sensor 100 can transmit ultrasonic waves. The AC voltage is applied to electrode 30 during transmission of ultrasonic waves, whereas the potential of electrode 30 is zero volt during reception of ultrasonic waves. As a result, ultrasonic sensor 100 can receive ultrasonic waves.

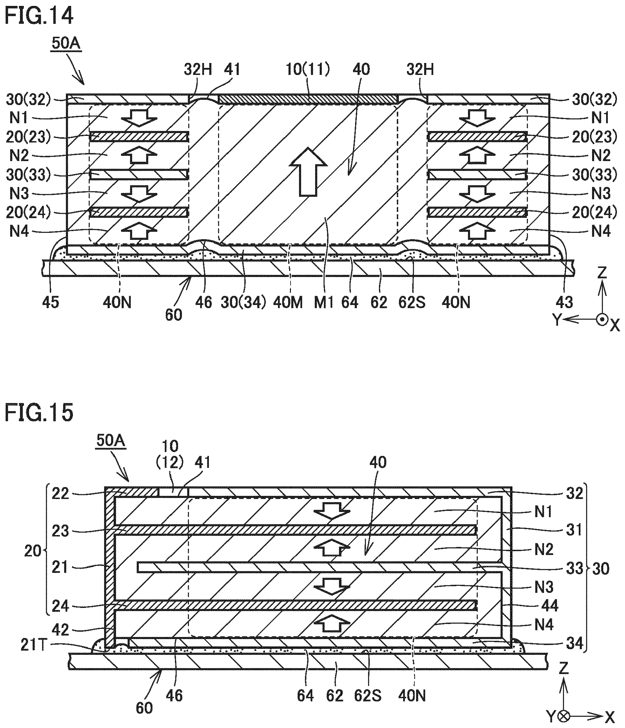

As illustrated in Fig. 8 and Fig. 10, a portion of upper surface 41 of piezoelectric layer 40 exposed between electrode 10 and electrode 30 is concave. The portion of the stack that separates reception portion 40M and transmission portion 40N from each other corresponds to a separating portion. The concave region of upper surface 41 is at least a part of the region corresponding to the separating portion. The upper surface of piezoelectric layer 40 in Fig. 8 to Fig. 10 corresponds to "first main surface" and the lower surface thereof corresponds to "second main surface". The concave region of the separating portion is presented as a non-claimed feature in the comparative example of Figures 8 and 10. In the first embodiment, discussed with reference to Figure 14, the separating portion has a convex region.

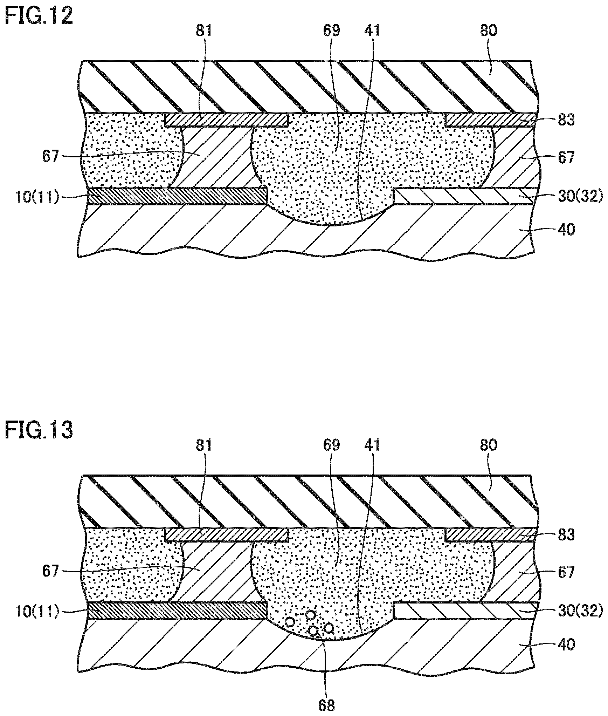

Fig. 12 illustrates a partial cross-sectional view in the vicinity of an interface in a state where FPC 80 is bonded to the upper surface of piezoelectric element 50 in the present embodiment. Electrode 10 and electrode 30 are arranged on the first main surface of the stack of the piezoelectric layers. The concave portion is formed in the region of the first main surface of the stack between electrode 10 and electrode 30. Wiring patterns 81 and 83 are provided on the surface of FPC 80. The upper surface of piezoelectric element 50 and FPC 80 are bonded using an anisotropic electrically-conductive adhesive. The anisotropic electrically-conductive adhesive is an adhesive in which solder particles are mixed in a resin serving as an adhesive, and bonding causes the solder particles to agglomerate in the vicinity of the electrodes made of metal to establish electrical connection. In the example illustrated in Fig. 12, formation of solder joint portions 67 at two locations is seen. Each solder joint portion 67 is formed as a result of agglomeration and melting of the solder particles. By solder joint portions 67, electrode 10 is electrically connected to wiring pattern 81 and electrode 30 is electrically connected to wiring pattern 83. Since the concave portion is formed between electrode 10 and electrode 30, a distance along the surface of the stack is longer than a distance in the absence of the concave portion. As a result, the probability of arrival of solder joint portion 67 at the adjacent undesired electrode is reduced.

In addition, as illustrated in Fig. 13, even when solder particles 68 do not completely adhere to electrode 10 and overflow laterally, solder particles 68 are received in the concave portion, and thus, the probability of arrival of the solder particles at adjacent electrode 30 is reduced.

### First Embodiment

While a configuration of a piezoelectric element 50A included in ultrasonic sensor 100 in the first embodiment is basically common to that described in the comparative example, the former is different from the latter on the following point.

Fig. 14 to Fig. 16 illustrate cross-sectional views of piezoelectric element 50A in the first embodiment corresponding to Fig. 8 to Fig. 10 in the comparative example, respectively.

In the present embodiment, at least a part of a region of a first main surface (upper surface 41) corresponding to a separating portion is convex in comparison with a region of the first main surface where a transmission electrode (electrode 30) is arranged and a region of the first main surface where a reception electrode (electrode 10) is arranged. The region of the first main surface hatched in Fig. 11 is convex. That is to say, the region between electrode 10 and electrode 30 is convex. This is a region corresponding to the separating portion. On the other hand, the first main surface is not convex in the region between electrode 20 and electrode 30.

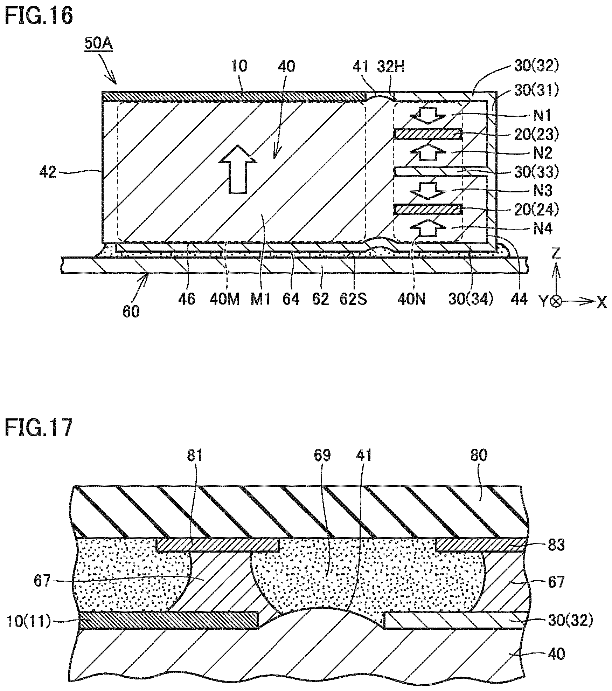

Fig. 17 illustrates a partial cross-sectional view in the vicinity of an interface in a state where FPC 80 is bonded to the upper surface of piezoelectric element 50A in the present embodiment. The convex portion is formed in the region of the first main surface of the stack between electrode 10 and electrode 30. Since the convex portion is formed between electrode 10 and electrode 30 as described above, a distance along the surface of the stack is longer than a distance in the absence of the convex portion. As a result, the probability of arrival of solder joint portion 67 at the adjacent undesired electrode is reduced. In addition, as illustrated in Fig. 17, even when the solder does not completely adhere to electrode 10 and overflow laterally, the solder is blocked by the convex portion, and thus, the probability of arrival of the solder at adjacent electrode 30 is reduced.

The concave portion or the convex portion described in the comparative example and the first embodiment may be formed by any method. The concave or convex portion may be formed on the upper surface of the stack by embossing using a mold having a preliminarily provided concave or convex portion, for example. Alternatively, the concave portion may be formed by performing some kind of removal processing on the upper surface.

Although the electrically-conductive material used for electrical connection to FPC 80 has been described as solder in the first and second embodiments, this is merely one example. The electrically-conductive material is not limited to solder and another material may be used.

### Modification to the Comparative Example

While a configuration of a piezoelectric element 50B included in ultrasonic sensor 100 in a modification of the comparative example discussed above , the modified comparative example is different on the following point.

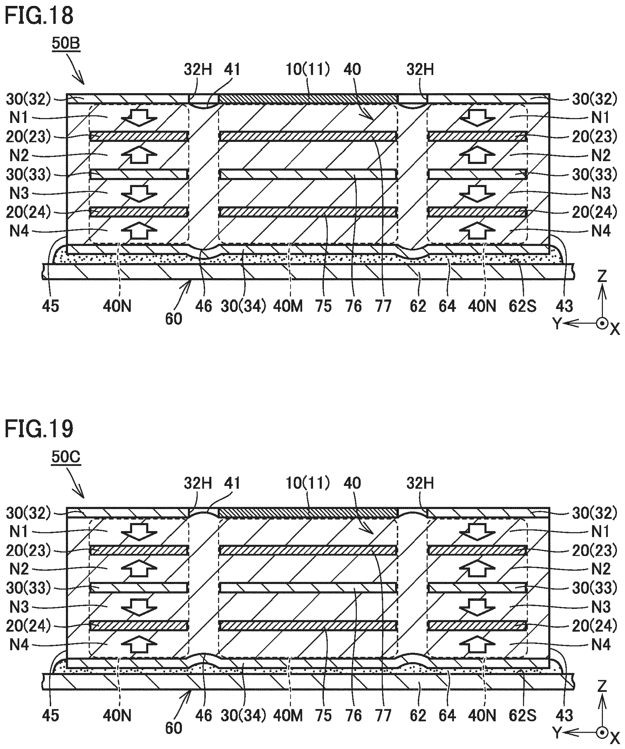

As illustrated in Fig. 18, in piezoelectric element 50B in the present example, a concave portion is formed in a region corresponding to the separating portion, of upper surface 41 as the first main surface of the stack, and internal electrodes 75, 76 and 77 are arranged in reception portion 40M. Internal electrodes 75, 76 and 77 may be dummy electrodes, or may be electrodes having some kind of function.

### Second Embodiment

While a configuration of a piezoelectric element 50C included in ultrasonic sensor 100 in a second embodiment is basically common to that described in the first embodiment, the former is different from the latter on the following point.

As illustrated in Fig. 19, in piezoelectric element 50C in the present embodiment, a convex portion is formed in a region corresponding to the separating portion, of upper surface 41 as the first main surface of the stack, and internal electrodes 75, 76 and 77 are arranged in reception portion 40M. Internal electrodes 75, 76 and 77 may be dummy electrodes, or may be electrodes having some kind of function.

The second embodiment can be expressed as follows. Transmission portion 40N and reception portion 40M in the piezoelectric element include a structure in which the piezoelectric layers and the conductor films are alternately arranged therein. In a plan view along the stacking direction (direction perpendicular to the first main surface (upper surface 41)), the separating portion includes a portion that does not include the conductor films therein.

In the second embodiment, the deformation phenomenon caused by the presence or absence of the internal electrodes can be used to form the convex portion in the region corresponding to the separating portion, of upper surface 41 as the first main surface of the stack. In the second embodiment, the convex portion is formed as described above, and thus, the effect described in the first embodiment can be obtained.

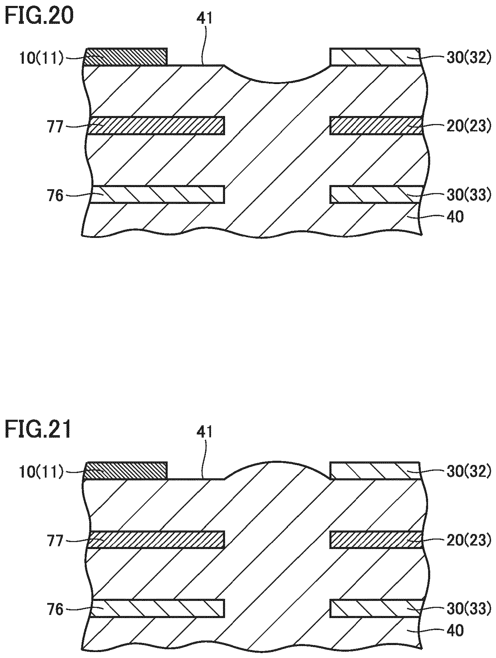

In the examples illustrated in Fig. 12, Fig. 13 and Fig. 17, an entire gap between the electrodes arranged on the first main surface of the stack is convex. However, the entire gap does not necessarily need to be convex. For example, as illustrated in Fig. 20 and Fig. 21, a part of the gap may be configured to be convex. In this case as well, the effect similar to those described in the first and second embodiments can be obtained. In Fig. 20 and Fig. 21, a position of the ends of internal electrodes 76 and 77 is different from a position of the end of electrode 10. When the presence or absence of the internal electrodes is used to form the convex portion on the first main surface of the stack, the convex portion tends to be formed in the region not having the internal electrodes. Due to this phenomenon, the region where the convex portion is formed does not match in some cases with the region seen as the gap between the electrodes arranged on the first main surface. Such a positional relation may result in the configuration in which a part of the gap is convex as illustrated in Fig. 20 and Fig. 21, respectively. With this configuration as well, the effect similar to those described in the first and second embodiments can be obtained.

The present invention is also applicable to various types of piezoelectric elements described below.

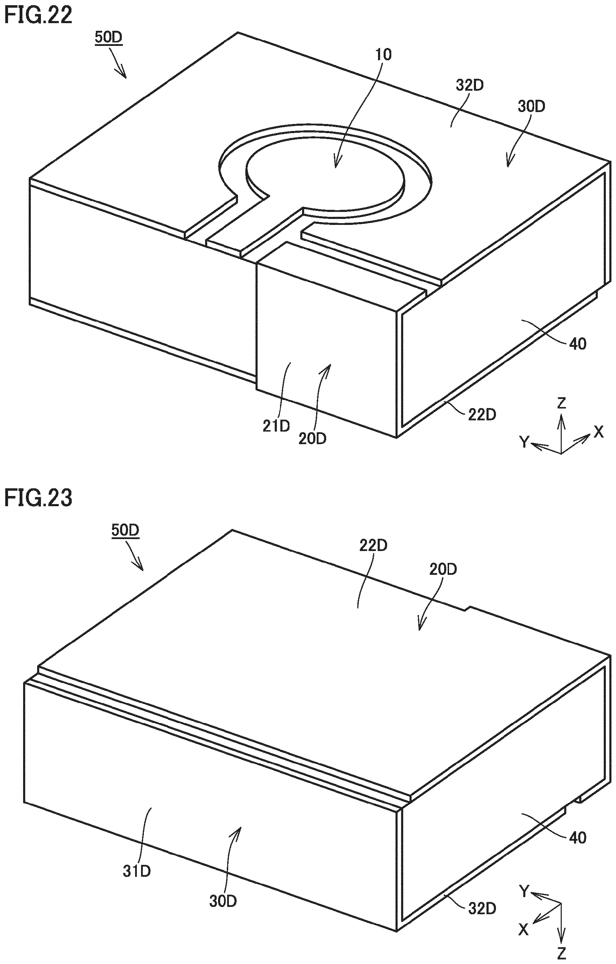

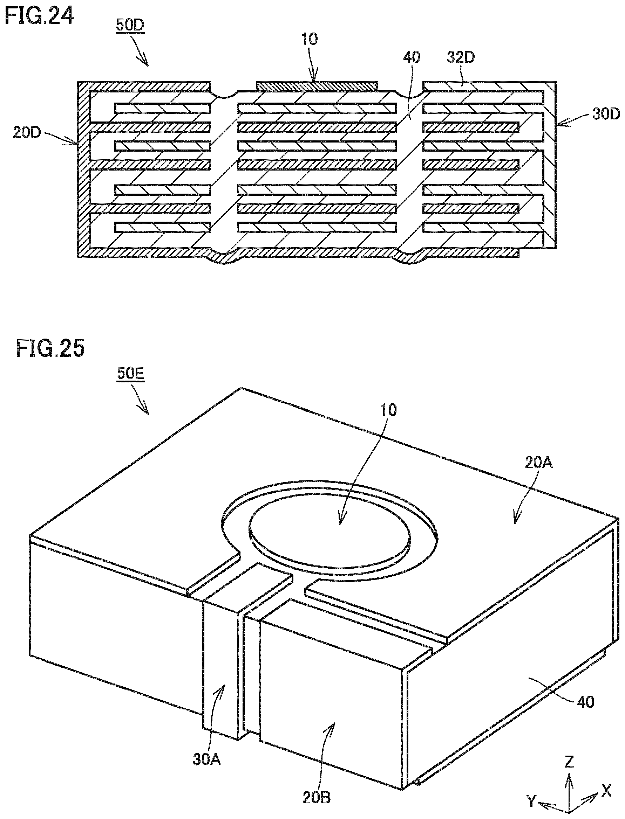

Fig. 22 to Fig. 24 illustrate a piezoelectric element 50D as one example of a three-terminal-type piezoelectric element. The three-terminal-type piezoelectric element refers to a type of piezoelectric element in which electrode 10, a part of an electrode 20D and a part of an electrode 30D are arranged on an upper surface, i.e., a first main surface, of piezoelectric element 50D as illustrated in Fig. 22. Fig. 22 illustrates an end face portion 21D of electrode 20D and an upper surface portion 32D of electrode 30D. Fig. 23 illustrates piezoelectric element 50D turned over from the state illustrated in Fig. 22. As illustrated in Fig. 23, most region of a lower surface, i.e., a second main surface, is covered with electrode 20D. Fig. 23 illustrates a lower surface portion 22D of electrode 20D and an end face portion 31D of electrode 30D. Furthermore, Fig. 24 illustrates a pseudo cross-sectional view of piezoelectric element 50D. However, Fig. 24 does not illustrate a cross-sectional view that is actually obtained by cutting piezoelectric element 50D straight at any place in Fig. 22, but illustrates, in a pseudo manner, a cross section of the portions directly below electrode 10, electrode 20D and electrode 30D illustrated in Fig. 22, which are aligned with the same width, for the convenience of description. In Fig. 24, a separating portion between electrode 10 and electrode 20D is also illustrated. A separating portion between electrode 10 and electrode 30D is also illustrated. In the example illustrated in Fig. 24, a convex portion is formed in these separating portions.

Although the three-terminal-type piezoelectric element has been illustrated by way of example, the piezoelectric element is not limited to the three-terminal-type piezoelectric element. The piezoelectric element may be of type having three or more terminals.

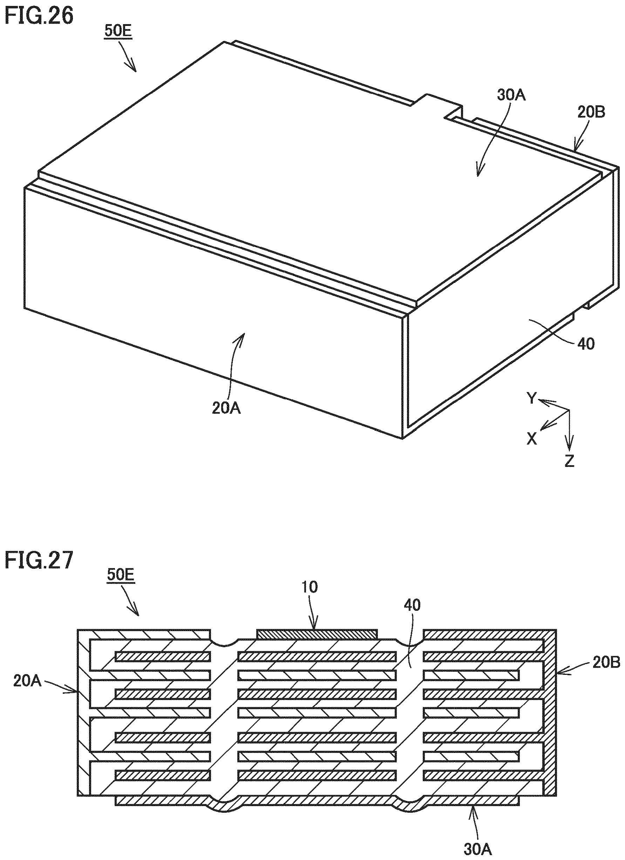

Fig. 25 to Fig. 26 illustrate a piezoelectric element 50E as one example of a four-terminal-type piezoelectric element. The four-terminal-type piezoelectric element refers to a type of piezoelectric element in which electrode 10, a part of an electrode 20A, a part of an electrode 20B, and a part of an electrode 30A are arranged on an upper surface of piezoelectric element 50E as illustrated in Fig. 25. Fig. 26 illustrates piezoelectric element 50E turned over from the state illustrated in Fig. 25. As illustrated in Fig. 26, most region of a lower surface, i.e., a second main surface, is covered with electrode 30A. Furthermore, Fig. 27 illustrates a pseudo cross-sectional view of piezoelectric element 50E. Similarly to Fig. 24, Fig. 27 is a cross-sectional view illustrating the aligned three portions for the sake of convenience. In this piezoelectric element 50E, each of electrodes 20A and 20B corresponds to the transmission electrode. Electrode 10 corresponds to the reception electrode.

### Third Embodiment

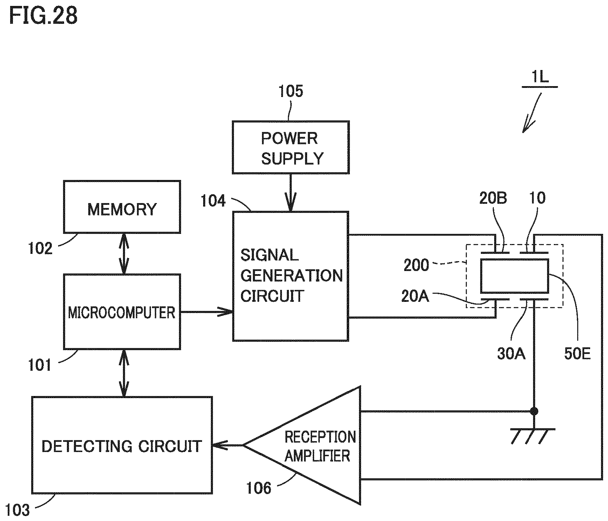

An ultrasonic sensor 200 in a third embodiment according to the present invention will be described. Fig. 28 is a diagram illustrating functional blocks of a sensor device 1L including ultrasonic sensor 200, and corresponds to Fig. 1 in the first embodiment. Ultrasonic sensor 200 includes a piezoelectric element 50E and piezoelectric element 50E has a four-terminal structure including electrodes 10, 20A, 20B, and 30A. Electrodes 20A and 20B are connected to signal generation circuit 104. Electrode 10 is connected to reception amplifier 106, and electrode 30A is grounded.

As illustrated in Fig. 2, ultrasonic sensor 100 in the present embodiment includes case 60, piezoelectric element 50 and FPC 80. Case 60 has a cylindrical shape with a bottom. Piezoelectric element 50 is bonded to inner bottom surface 62S of case 60 such that the second main surface opposes inner bottom surface 62S of case 60. FPC 80 includes a plurality of wirings. FPC 80 is a wiring lead-out component bonded to the first main surface such that the plurality of wirings individually establish electrical connections to the reception electrode and the transmission electrode. Piezoelectric element 50 herein is the piezoelectric element configured as previously described in any one of the embodiments.

With this configuration, ultrasonic sensor 100 in the present embodiment can be an ultrasonic sensor with reduced probability of occurrence of a short circuit caused by overflow of the electrically-conductive material at the bonded place between the piezoelectric element and the wiring lead-out component.

The wiring lead-out component is preferably bonded to the first main surface (upper surface 41 of the stack) using an anisotropic electrically-conductive adhesive. When the anisotropic electrically-conductive adhesive is used for bonding as described above, the effect of reducing the probability of occurrence of a short circuit can be particularly remarkably enjoyed. Although Fig. 2 illustrates the example in which the wiring lead-out component is FPC 80, the wiring lead-out component may be another type of component.

The anisotropic electrically-conductive adhesive preferably includes solder. When the anisotropic electrically-conductive adhesive includes solder as an electrically-conductive material as described above, the effect of reducing the probability of occurrence of a short circuit can be particularly remarkably enjoyed.

It should be noted that some of the above-described embodiments may be combined as appropriate.

It should be understood that the embodiments disclosed herein are illustrative and not limitative in any respect. The scope of the present invention is defined by the terms of the claims, rather than the description above.

### REFERENCE SIGNS LIST

1, 1L sensor device; 10 electrode (reception electrode); 10C, 20C, 30C connecting place; 11 disk portion; 20, 20A, 20B, 20D, 30D, 30 electrode; 21, 21D, 31D end face portion; 21T end portion; 22, 32D upper surface portion; 22D lower surface portion; 23, 24 intermediate portion; 23H, 24H hollowed portion; 23T, 24T cutout portion; 30A electrode (grounded electrode); 31 end face portion; 32H, 33H hollowed portion; 32T, 33T cutout portion; 33 intermediate portion; 40 piezoelectric layer; 40M reception portion; 40N transmission portion; 41 upper surface (of piezoelectric layer); 42, 44 side surface (of piezoelectric layer); 46 lower surface; 50, 50A, 50B, 50C, 50D, 50E piezoelectric element; 60 case; 61 cylindrical portion; 62 bottom portion; 62S inner bottom surface; 62T outer surface; 63 sound absorbing material; 64 adhesive; 65 bonding agent; 67 solder joint portion; 68 solder particle; 69 resin portion; 71, 72 filler; 75, 76, 77 internal electrode; 80 FPC; 81, 82, 83 wiring pattern; 100, 200 ultrasonic sensor; 101 microcomputer; 102 memory; 103 detecting circuit; 104 signal generation circuit; 105 power supply; 106 reception amplifier; N1 to N4 first piezoelectric layer; M1 second piezoelectric layer.

## Claims

1. A piezoelectric element (50) comprising
a stack formed of a plurality of piezoelectric layers (40) and having a first main surface (41) and a second main surface (46) facing in opposite directions along a stacking direction,
the stack including a transmission portion (40N), a reception portion (40M), and a separating portion that separates the transmission portion (40N) and the reception portion (40M) from each other,
a transmission electrode (20) being arranged so as to cover a region of the first main surface (41) corresponding to the transmission portion (40N),
a reception electrode (10) being arranged so as to cover a region of the first main surface corresponding to the reception portion (40M),
the transmission electrode (20) sandwiching at least a part of the plurality of piezoelectric layers (40), together with a conductor film arranged in the stack or on the second main surface (46),
the reception electrode (10) sandwiching at least a part of the plurality of piezoelectric layers (40), together with the conductor film arranged in the stack or on the second main surface (46),
at least a part of a region of the first main surface (41) corresponding to the separating portion being convex in comparison with a region of the first main surface where the transmission electrode (20) is arranged and a region of the first main surface (41) where the reception electrode (10) is arranged.

2. The piezoelectric element (50) according to claim 1, wherein
the transmission portion (40N) and the reception portion (40M) include a structure in which the piezoelectric layers (40) and the conductor films are alternately arranged therein, and
in a plan view along the stacking direction, the separating portion includes a portion that does not include the conductor films therein.

3. An ultrasonic sensor (100) comprising:
a case (60) having a cylindrical shape with a bottom;
the piezoelectric element (50) as recited in claim 1 or 2, the piezoelectric element (50) being bonded to an inner bottom surface of the case (60) such that the second main surface (46) opposes the inner bottom surface of the case; and
a wiring lead-out component (80) including a plurality of wirings and bonded to the first main surface such that the plurality of wirings individually establish electrical connections to the reception electrode (10) and the transmission electrode (20).

4. The ultrasonic sensor according to claim 3, wherein
the wiring lead-out component (80) is bonded to the first main surface (41) using an anisotropic electrically-conductive adhesive.

5. The ultrasonic sensor according to claim 4, wherein
the anisotropic electrically-conductive adhesive includes solder.

## Patentansprüche

1. Piezoelektrisches Element (50), umfassend:
einen Stapel, der von einer Vielzahl piezoelektrischer Schichten (40) gebildet wird und eine erste Hauptfläche (41) und eine zweite Hauptfläche (46) aufweist, die entlang einer Stapelungsrichtung in einander entgegengesetzte Richtungen weisen,
wobei der Stapel einen Übertragungsteil (40N), einen Empfangsteil (40M) und einen Trennteil, der den Übertragungsteil (40N) und den Empfangsteil (40M) voneinander trennt,
eine Übertragungselektrode (20), die angeordnet ist, um eine Region der ersten Hauptfläche (41), die dem Übertragungsteil (40N) entspricht, zu bedecken,
eine Empfangselektrode (10), die angeordnet ist, um eine Region der ersten Hauptfläche, die dem Empfangsteil (40M) entspricht, zu bedecken,
wobei die Übertragungselektrode (20) die Vielzahl von piezoelektrischen Schichten (40) wenigstens teilweise zusammen mit einer in dem Stapel oder auf der zweiten Hauptfläche (46) angeordneten Leiterfolie schichtet,
wobei die Empfangselektrode (10) die Vielzahl von piezoelektrischen Schichten (40) wenigstens teilweise zusammen mit der in dem Stapel oder auf der zweiten Hauptfläche (46) angeordneten Leiterfolie schichtet,
wobei wenigstens ein Teil einer Region der ersten Hauptfläche (41), das dem Trennteil entspricht, verglichen mit einer Region der ersten Hauptfläche, in der die Übertragungselektrode (20) angeordnet ist, und einer Region der ersten Hauptfläche (41), in der die Empfangselektrode (10) angeordnet ist, konvex ist.

2. Piezoelektrisches Element (50) nach Anspruch 1, wobei
der Übertragungsteil (40N) und der Empfangsteil (40M) eine Struktur beinhalten, in der die piezoelektrischen Schichten (40) und die Leiterfolien abwechseln angeordnet sind, und
der Trennteil in einer Draufsicht entlang der Stapelrichtung einen Teil beinhaltet, in dem die Leiterfolien nicht enthalten sind.

3. Ultraschallsensor (100), umfassend:
ein Gehäuse (60) mit einer zylindrischen Form mit einem Boden;
das piezoelektrische Element (50) nach Anspruch 1 oder 2, wobei das piezoelektrische Element (50) an eine innere Bodenfläche des Gehäuses (60) angefügt ist, so dass die zweite Hauptfläche (46) der inneren Bodenfläche des Gehäuses entgegengesetzt ist; und
eine herausführende Verdrahtungsanschlusskomponente (80), die mehrere Verdrahtungen beinhaltet und an die erste Hauptfläche angefügt ist, so dass die mehreren Verdrahtungen einzeln elektrische Verbindungen mit der Empfangselektrode (10) und der Übertragungselektrode (20) herstellen.

4. Ultraschallsensor nach Anspruch 3, wobei
die herausführende Verdrahtungsanschlusskomponente (80) mit einem anisotropen elektrisch leitenden Klebstoff an die erste Hauptfläche (41) angefügt ist.

5. Ultraschallsensor nach Anspruch 4, wobei der anisotrope elektrisch leitende Klebstoff Lötmittel beinhaltet.

## Revendications

1. Elément piézoélectrique (50) comprenant :
une pile formée d'une pluralité de couches piézoélectriques (40) ayant une première surface principale (41) et une deuxième surface principale (46) faisant face dans des directions opposées le long d'une direction d'empilage,
la pile comprenant une partie de transmission (40N), une partie de réception (40M), et une partie de séparation qui sépare la partie de transmission (40N) et la partie de réception (40M) l'une de l'autre,
une électrode de transmission (20) étant arrangée de manière à couvrir une région de la première surface principale (41) correspondant à la partie de transmission (40N),
une électrode de réception (10) étant arrangée de manière à couvrir une région de la première surface principale correspondant à la partie de réception (40M),
l'électrode de transmission (20) prenant en sandwich au moins une partie de la pluralité de couches piézoélectriques (40), avec un film conducteur arrangé dans la pile ou sur la deuxième surface principale (46),
l'électrode de réception (10) prenant en sandwich au moins une partie de la pluralité de couches piézoélectriques (40), avec le film conducteur arrangé dans la pile ou sur la deuxième surface principale (46),
au moins une partie d'une région de la première surface principale (41) correspondant à la partie de séparation étant convexe en comparaison à une région de la première surface principale (41) où l'électrode de transmission (20) est arrangée et à une région de la première surface principale (41) où l'électrode de réception (10) est arrangée.

2. Elément piézoélectrique (50) selon la revendication 1, dans lequel
la partie de transmission (40N) et la partie de réception (40M) comprennent une structure dans laquelle les couches piézoélectriques (40) et les films conducteurs sont arrangés dedans en alternance, et
en vue plane le long de la direction d'empilage, la partie de séparation comprend une partie qui ne comprend pas les films conducteurs dedans.

3. Capteur à ultrasons (100) comprenant :
un boîtier (60) ayant une forme cylindrique avec un fond ;
l'élément piézoélectrique (50) selon la revendication 1 ou 2, l'élément piézoélectrique (50) étant joint à une surface intérieure du fond du boîtier (60) de telle sorte que la deuxième surface principale (46) est à l'opposé de la surface intérieure du fond du boîtier ; et
un composant de sortie de fils (80) comprenant une pluralité de fils et joint à la première surface principale de telle sorte que la pluralité de fils établissent individuellement des connexions électriques avec l'électrode de réception (10) et l'électrode de transmission (20).

4. Capteur à ultrasons selon la revendication 3, dans lequel
le composant de sortie de fils (80) est joint à la première surface principale (41) en utilisant un adhésif électriquement conducteur anisotrope.

5. Capteur à ultrasons selon la revendication 4, dans lequel
l'adhésif électriquement conducteur anisotrope comprend une soudure.
